(19) Europäisches Patentamt / European Patent Office / Office européen des brevets

(11) **EP 4 318 003 B1**

(12) **EUROPEAN PATENT SPECIFICATION**

(45) Date of publication and mention of the grant of the patent:
**22.07.2026 Bulletin 2026/30**

(51) International Patent Classification (IPC):
**G01R 31/327** *(2006.01)* **H01H 71/16** *(2006.01)*
**H01H 71/74** *(2006.01)* **H01H 69/01** *(2006.01)*

(21) Application number: **22866055.1**

(52) Cooperative Patent Classification (CPC):
**G01R 31/327; H01H 69/01; H01H 71/16; H01H 71/7436;** H01H 3/42

(22) Date of filing: **16.03.2022**

(86) International application number:
**PCT/CN2022/081090**

(87) International publication number:
**WO 2023/035577 (16.03.2023 Gazette 2023/11)**

(54) **CALIBRATION METHOD FOR TIME-DELAY CHARACTERISTICS OF SWITCH-WITH-BIMETAL**

KALIBRIERUNGSVERFAHREN FÜR DIE ZEITVERZÖGERUNGSCHARAKTERISTIK EINES SCHALTERS MIT BIMETALL

PROCÉDÉ DE CALIBRATION DES CARACTÉRISTIQUES DE DÉCALAGE TEMPOREL D'UN INTERRUPTEUR À BILAME

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **07.09.2021 CN 202111045315**

(43) Date of publication of application:
**07.02.2024 Bulletin 2024/06**

(73) Proprietor: **Zhejiang Chint Electrics Co., Ltd.**
**Yueqing, Zhejiang 325603 (CN)**

(72) Inventors:
• **WANG, Binming**
**Yueqing, Zhejiang 325603 (CN)**
• **XIAO, Tifeng**
**Yueqing, Zhejiang 325603 (CN)**
• **YE, Yang**
**Yueqing, Zhejiang 325603 (CN)**
• **YUE, Xilei**
**Yueqing, Zhejiang 325603 (CN)**
• **HU, Jianguo**
**Yueqing, Zhejiang 325603 (CN)**
• **LIN, Zhuxin**
**Yueqing, Zhejiang 325603 (CN)**

(74) Representative: **Petraz, Gilberto Luigi et al**
**GLP S.r.l.**
**Viale Europa Unita, 171**
**33100 Udine (IT)**

(56) References cited:
CN-A- 103 645 436    CN-A- 104 576 227
CN-A- 109 212 409    CN-A- 110 568 348
CN-A- 111 048 361    JP-A- 2013 073 782

EP 4 318 003 B1

## Description

## TECHNICAL FIELD

The present invention relates to the field of low-voltage electrical appliances, in particular to a calibration method for time-delay characteristics of switch-with-bimetal.

## BACKGROUND ART

General requirements for thermal overload relays and motor starters (overload protection characteristics) are being stable within 2 hours under 1.05 times rated current and not tripped and being tripped within 2 hours under 1.2 times rated current. Therefore, in the process of producing thermal overload relays and motor starters, it needs a long time to electrify and calibrate them (more than 1 hour), so as to stably heat a bimetallic strip under rated current, and then manually adjust the tripping point of the mechanism to match the point corresponding to the bent position of the bimetallic strip heated, such as Chinese Patent CN103645436A. Therefore, deficiencies such as inefficiency, strong influence of human factors and instability of adjusted pass rate occur in the existing calibration method.

## SUMMARY OF THE INVENTION

The present invention aims to overcome the deficiencies of the prior art, therefor provides a calibration method for time-delay characteristics of switch-with-bimetal, which is suitable for automatic operation and has high pass rate and high efficiency of calibration; further provides a calibration method for time-delay characteristics of relays, which is suitable for automatic operation and has high pass rate and high efficiency of calibration; further provides a calibrating system for time-delay characteristics of relays that applies the calibration method for time-delay characteristics of relays, which realizes automatic and fast calibration for time-delay characteristics of relays.

In order to achieve the above object, the technical scheme adopted in the present invention is as follows:

A calibration method for time-delay characteristics of switch-with-bimetal, comprising the operation of

pre-adjusting operation of a tripping travel, that is, adjusting the tripping travel of a switch-with-bimetal through adjustment to the relative position of a bimetallic strip of the switch-with-bimetal and a transmission structure;

calibration operation of a tripping point, executing calibration operation of the tripping point of a current level "a" of the switch-with-bimetal after ending pre-adjusting operation of a tripping travel, the current level "a" representing any current level of the switch-with-bimetal, that is, inputting a first calibrating current to a main contact system of the switch-with-bimetal and keeping a first set time length, the first calibrating current being 2-6 times the rated current of the current level "a" of the switch-with-bimetal, the first set time length being 10-120s, then inputting a second calibrating current to the main contact system of the switch-with-bimetal and keeping a second set time length, the second calibrating current being 1.05-1.2 times the rated current of the current level "a" of the switch-with-bimetal, the second set time length being 1-60s; at the end of the second set time length, twisting an adjusting cam used for adjusting the current level of the switch-with-bimetal until the main contact system or a supplementary normally-closed contact system of the switch-with-bimetal is disconnected, keeping inputting the second calibrating current to the main contact system of the switch-with-bimetal in the process of twisting the adjusting cam;

for the switch-with-bimetal including a plurality of current levels, just repeating the calibration operation at the tripping point;

after a first time of calibration operation of the tripping point of the switch-with-bimetal is done, if a calibration result is unqualified, repeating the pre-adjusting operation of the tripping travel, and then executing calibration operation of the tripping point again.

Further, the adjusting cam is brought to rotate through a cam-adjusting motor; when the cam-adjusting motor drives the adjusting cam to rotate to enable the supplementary normally-closed contact system of the switch-with-bimetal to break contact, the angle where the cam-adjusting motor is positioned is the calibration result, if the calibration result is within an qualified angle range, the calibration result is qualified, if the calibration result is not within the qualified angle range, the calibration result is qualified.

The calibration method for time-delay characteristics of switch-with-bimetal according to present invention can realize automatic, fast and equivalently-effective calibration for time-delay characteristics of switch-with-bimetal, providing the suitability for automatic operation, and raising the pass rate and the efficiency of the calibration for time-delay characteristics of switch-with-bimetal.

## BRIEF DESCRIPTION OF THE DRAWINGS

FIG.1 is a structure diagram of the calibrating system for time-delay characteristics of relays, not covered by the claims;

FIG.2 is a structure diagram of a pre-checking/marking unit of the calibrating system of FIG. 1;

FIG.3 is a structure diagram of a relay of the calibrating system of FIG. 1;

FIG.4 is a structure diagram of a calibrating unit of the calibrating system of FIG. 1;

FIG.5 is a structure diagram of a calibrating mechanism of the calibrating system of FIG. 1;

FIG.6 is a structure diagram of the cooling unit of FIG. 5;

FIG.7 is another structure diagram of the cooling unit;

FIG.8 is a structure diagram of a terminal-checking/-marking unit of the calibrating system of FIG. 1;

FIG.9a is a side projected structure diagram of a relay of the calibrating system of FIG.1 showing the first adjusting cam not marked with the current level scales;

FIG.9b is a side projected structure diagram of the relay of FIG. 9a showing the first adjusting cam marked with the current level scale 2.5A;

FIG.9c is a side projected structure diagram of the relay of FIG. 9a and 9b showing the first adjusting cam marked with the current level scales 2.5A, 2.0A and 1.6A .

## DETAILED DESCRIPTION OF THE PREFERRED EMBODIMENTS

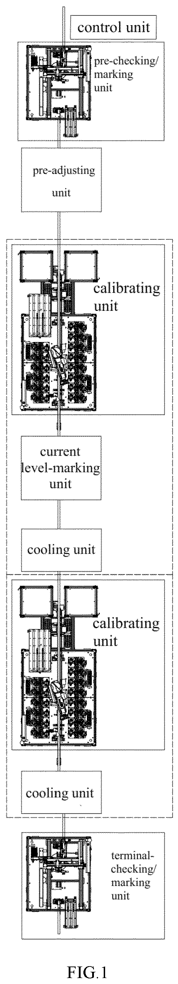

We shall further describe the specific embodiments of the calibration method for time-delay characteristics of switch-with-bimetal, a calibration method for time-delay characteristics of relays and the system thereof in combination with the examples given in FIGs. 1-8 as follows. The calibration method for time-delay characteristics of switch-with-bimetal according to the present invention is not limited to the description of the following examples.

The present invention discloses a calibration method for time-delay characteristics of switch-with-bimetal, which includes the following operation.

Pre-adjusting operation of a tripping travel, that is, adjusting the tripping travel of a switch-with-bimetal through adjustment to the relative position of a bimetallic strip of the switch-with-bimetal and a transmission structure. It should be noted that the transmission structure refers to a structure used to transmit the driving force caused by deformation of a heated bimetallic strip, for example, a jump buckle of an operating mechanism, a bimetallic strip is deformed under heat to drive the jump buckle to act, so as to trip the operating mechanism, in this way, tripping the operating mechanism enables a main contact system of the switch-with-bimetal to break contact (such as a motor starter) or a supplementary normally-closed contact system of the switch-with-bimetal to break contact (such as a thermal overload relay).

Executing calibration operation of a tripping point, executing calibration operation of the tripping point of the current level "a" of the switch-with-bimetal after ending the pre-adjusting operation of a tripping travel, where the current level "a" represents any one of current levels of the switch-with-bimetal, that is, inputting a first calibrating current to a main contact system of the switch-with-bimetal and keeping a first set time length, where the first calibrating current is 2-6 times the rated current of the current level "a" of the switch-with-bimetal, and the first set time length is 10-120s, then inputting a second calibrating current to the main contact system of the switch-with-bimetal and keeping a second set time length, where the second calibrating current is 1.05-1.2 times the rated current of the current level "a" of the switch-with-bimetal, and the second set time length is 1-60s; at the end of the second set time length, twisting an adjusting cam used to adjusting the current level of the switch-with-bimetal until the main contact system or a supplementary normally-closed contact system of the switch-with-bimetal is disconnected, keeping inputting the second calibrating current to the main contact system of the switch-with-bimetal in the process of twisting the adjusting cam. It should be pointed out that the first set time length and the second set time length are related to the heating component structure, power, flection ratio of bimetallic strip, overall product structure and other factors, and the specific values are obtained through analysis and statistics on experimental data.

Preferably, in the calibration method for time-delay characteristics of switch-with-bimetal according to the present invention, a cam-adjusting motor drives the adjusting cam to rotate, when the cam-adjusting motor drives the adjusting cam to rotate to enable the supplementary normally-closed contact system of the switch-with-bimetal to break contact, the angle where the cam-adjusting motor is positioned is a calibration result, if the calibration result is within an qualified angle range, the calibration result is qualified, if the calibration result is no longer within an qualified angle range, the calibration result is unqualified.

For switch-with-bimetal includes a plurality of current levels, it is all done to just repeat the calibration operation of the tripping point. That is to say, repeating the calibration operation of the tripping point realizes calibration operation of all tripping points of the current levels of the switch-with-bimetal or calibration operation of part of specific tripping points of the current levels (For example, when a thermal overload relay includes a plurality of current levels, only of two tripping points of the current levels at both ends of thermal overload relay the calibration needs to be executed).

After the switch-with-bimetal has ended its first calibration operation of the tripping point, if the calibration result is unqualified, repeat the pre-adjusting operation of a tripping travel, and then execute calibration operation of the tripping point again.

In the calibration method for time-delay characteristics of switch-with-bimetal according to the present invention, the pre-adjusting operation of a tripping travel and the calibration operation of a tripping point are carried out step by step, enabling the method of the present invention to be more suitable for automation; moreover, in the case of inputting currents with different gradients to the main contact system of the switch-with-bimetal, the first calibrating current causes a rapid impact on the bimetallic strip of the switch-with-bimetal, and then the second calibrating current forms a stable effect on the bimetallic strip of the switch-with-bimetal, so as to improve the efficiency of the calibration operation of the tripping point while ensure the accuracy of the calibration operation of the tripping point. In addition, in the method of the present invention, the cam-adjusting motor is used to adjust the adjusting cam, ensuring the timeliness and consistency of the adjustment process, and conducing to improvement to the accuracy of the calibration operation of the tripping point.

A calibration method for time-delay characteristics of relays, not covered by the claims, is also disclosed.

The calibration method for time-delay characteristics of relays includes the following steps.

S1. Twisting the adjusting screw 100s of the relay to execute the first-time pre-adjusting of the tripping travel of the relay.

Preferably, S1 includes the following sub-steps.

S11. Retrieving a corresponding travel debugging parameter X according to the product status information of the relay.

Preferably, the product status information includes a production line number, a production date, a product specification, and a product serial number (the product serial number may be a numeric serial number, an alphabetic serial number, or a combination serial number of number and alphabet).

S12. Identifying the state of the supplementary contact system of the relay, which includes a make-contact/breaker-contact state of a supplementary normally-closed contact system and a make-contact/break-contact state of a supplementary normally-opened contact system.

S13. the first-time pre-adjusting operation of the tripping travel of the relay is executed according to the state of the supplementary contact system and the travel debugging parameter X.

Preferably, S13 includes the following sub-steps.

S 131. In the case of the state of the supplementary contact system of the relay is the supplementary normally-closed contact being in make-contact state, twisting the adjusting screw in the first direction until enabling the supplementary normally-closed contact system 100c to break contact, then twisting the adjusting screw by $n_0$ circles in the first or second direction in accordance with the travel debugging parameter X, where $n_0$ = X/P, P is the pitch of the adjusting screw; the first direction and second direction are opposite to each other.

S132. In the case of the state of the supplementary contact system of the relay the supplementary normally-opened contact being in make-contact state, twisting the adjusting screw in the second direction until enabling the supplementary normally-closed contact system 100c to break contact, enabling the state of the supplementary contact system to switch to the supplementary normally-closed contact being in make-contact state, then executing S131.

Preferably, the first direction is counterclockwise, the second direction is clockwise.

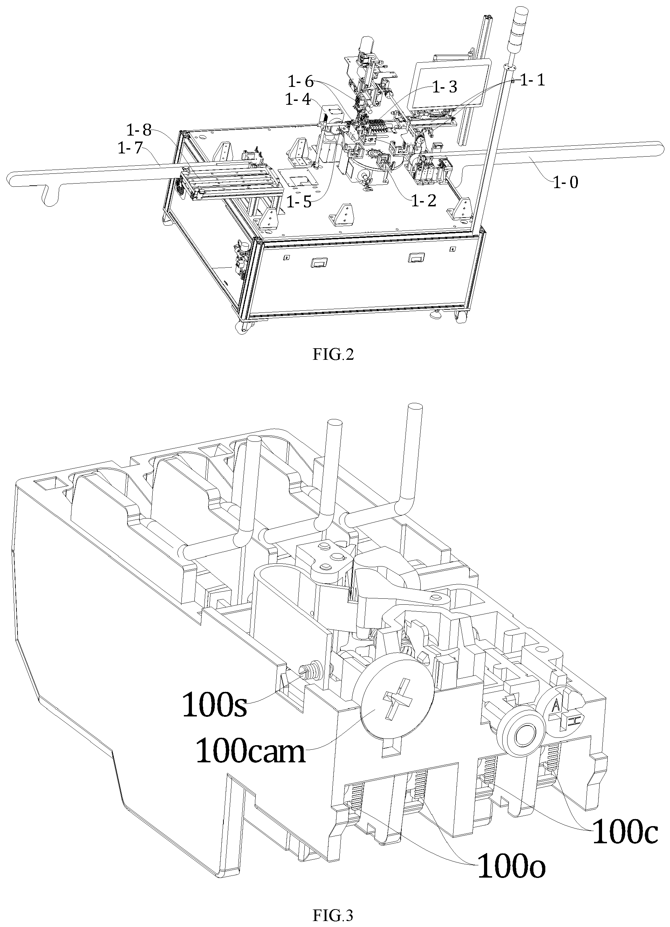

As shown in FIG.3, the adjusting screw 100s of the relay cooperates with the bimetallic strip, twisting the adjusting screw 100s enables the tripping travel of the relay to be pre-adjusted, that is, the relative position of the bimetallic strip and the transmission structure corresponding to it is adjusted.

S2 includes the following sub-steps.

S21. Executing calibration operation of the tripping point of the current level $J_a$ of the relay, where the current level $J_a$ represents any one of current level of the relay, that is, inputting a third calibrating current to the main contact system of the relay and keeping a third set time length, where the third calibrating current is 2-6 times the rated current of the current level $J_a$ of the relay, and the third set time length is 10-120s, then inputting a fourth calibrating current to the main contact system of the relay and keeping a fourth set time length, where the fourth calibrating current is 1.05-1.2 times the rated current of the current level $J_a$ of the relay, and the fourth set time length is 1-60s; the adjusting cam of the relay is embodied as the first adjusting cam 100cam, at the end of the fourth set time length, twisting the first adjusting cam 100cam until enabling the supplementary normally-closed contact system 100c of the relay to break contact, keeping inputting the fourth calibrating current to the main contact system in the process of twisting the first adjusting cam 100cam. Further, the first calibrating current can be split into multi-gradient currents and input into the relay in proper order, and the first calibrating current is still kept for the first set time length; for example, the heat-generating capacity of the bimetallic strip has the following relation with current, electrification time length, and resistance: heat - generating capacity = (current)$^2$ × resistance × electrification time length, therefore, under the same conditions, the higher the multiple of current, the shorter the kept-for time length, according to the above principle, the first calibrating current can be split into multi-gradient currents that decrease sequentially, but the corresponding kept-for time lengths increase sequentially.

Preferably, in the calibration method for time-delay characteristics of relays, a cam-adjusting motor drives the first adjusting cam 100cam to rotate, when the cam-adjusting motor drives the first adjusting cam 100cam to rotate to enable the supplementary normally-closed contact system of the relay to break contact, the angle where the cam-adjusting motor is positioned is a first angle, which is a calibration result, if the first angle is not within an qualified angle range, the calibration result is unqualified. The qualified angle range varies according to the design of different products, for example, it may be 100°-180° or 150°-230°. Further, the qualified angle range can be by gradient divided into multiple angle ranges, the relays qualified to the calibration operation are counted to different angle ranges, so as to calculate the proportion of the relays in the setting scaled by each angle range. For example, if the qualified angle range is 30°-60°, and the qualified angle range is divided into three angle ranges, which may be 30°-40° for a range, 41°-50° for a range, and 51°-60° for a range. Of course, the range of each angle range can be adjusted according to actual needs. It should also be noted that the position of each tripping point of the current level of the relay can also be recorded through visual inspection, such as CCD detection.

Preferably, among the relays that end their first calibration operation of a tripping point, after the proportion of the relays with the results unqualified to the calibration operation exceeds a set limit, the travel-debugging parameter X corresponding to the relays unqualified to the calibration operation is adjusted according to the calibration results of the relays unqualified to the calibration operation. Further, the set limit is 5%-15%. Further, the set limit is 6%, 8%, 10% or 12%. Further, when the result of the first calibration operation of the tripping point of the relay is less than the lower limit of the qualified angle range, the travel-debugging parameter X corresponding to the relay declines by 5-15% (preferably 10%); when the result of the first calibration operation of the tripping point of the relay is more than the upper limit of the qualified angle range, the travel-debugging parameter X corresponding to the relay rises by 5-15% (preferably 10%). The travel-debugging parameter X is a dynamic value, originally set by manual based on theoretical calculation and measured values of products, and its value is related to factors such as bimetal characteristics of products, resistance values of thermal elements, tripping force and friction of the system etc., the travel-debugging parameter X of the product passing qualified time-delay calibration can be measured and combined with a theoretically-calculated value to determine the optimal value of the travel-debugging parameter X; the value of the travel-debugging parameter X can be adjusted according to the calibration result of the first calibration operation of the tripping point of the product, and the products with diverse current specifications correspond to diverse travel-debugging parameters X, but a case that individual products with a diverse current specifications are of an identical travel-debugging parameter X also occurs.

S22. After the relay ends its first calibration operation of the tripping point of the current level J_a, if the calibration result is unqualified, twisting the adjusting screw 100s of the relay to execute a second-time pre-adjusting operation the tripping travel of the relay, then entering S21; if the calibration result is qualified, then entering S3.

Preferably, the tripping travel of the relay (the relay with an unqualified result from the first calibration operation of the tripping point) is executed the second-time pre-adjusting operation according to the following formula:

$$Q = \frac{(A-W)\times T}{P}.$$

Where Q represents a number of turns needed to twist the adjusting screw 100s at the time of the second-time pre-adjusting operation of the tripping travel of the relay; twisting the adjusting screw 100s in the first direction as Q is a positive number, twisting the adjusting screw 100s in the second direction as Q is a negative number; A is the first angle; W is an angle value of the tripping point; T is a rising measure of the adjusting cam, which is a designed size of products; P is a pitch of the adjusting screw 100s.

Preferably, W is determined by the design adjustment margin of the relay itself; for example, the adjustment margin of the relay is 300°, wherein the angle between the maximum and minimum current levels for the relay specified as 2.5A is 180°, the adjustment margin is 300°-180°=120°; W is preferably 50°.

S3 includes the following sub-steps.

S31. Cooling the relay.

It should be pointed that for the relay including a plurality of current levels, S21 and S31 are repeated to execute the calibration operation of each tripping point of the current level of the relay or the calibration operation of specific tripping point(s) of the current levels of the relay (For example, the calibration operation of the tripping points of the maximum and minimum current levels of the relay). Further, for the relay needing to execute the calibration operation for a plurality of current levels, preferably, the calibration operation is executed of the tripping point of each current level in the order of the size of the current level, conducing to improvement to the pass rate of the calibration results; for example, the relay includes three current levels $J_1$A, $J_2$A, $J_3$A, where $J_1 > J_2 > J_3$, if executing the calibration operation of the tripping points of the three current levels, the calibration is respectively executed of the tripping points of the three current levels according to the order $J_1$A, $J_2$A, $J_3$A, if executing the calibration operation of the tripping points of the maximum and minimum current levels, the calibration operation of the tripping point of the current $J_1$A is firstly executed, next the tripping point of the current level

$J_3A$ .

Preferably, the calibration method for time-delay characteristics of relays further includes the step of checking the supplementary contact performance of the supplementary contact system of the relay before executing S1. Further, the supplementary contact performance of the supplementary contact system of the relay refers to electrification performance of supplementary contact system pairs, such as whether a supplementary contact system is normally connected or disconnected, contact resistance of a supplementary contact system, etc., only necessity to ensure well supplementary contact performance of the relay guarantees the normal progress of the next steps; if the supplementary contact performance of the relay is qualified, entering the next step, if not, the relay is classified as an unqualified product.

Specifically, the supplementary contact performance of the supplementary contact system of the relay is checked through the following operation steps: a. checking the state of the supplementary normally-closed contact system, if conduction is qualified, if non-conduction, it is unqualified; b. pressing a test button and keeping, if the supplementary normally-closed contact system turns to non-conduction and the supplementary normally-opened contact system turns to conduction, it is qualified, if not, it is unqualified; c. releasing the test button, if the supplementary normally-closed contact system returns to conduction and the supplementary normally-opened contact system returns to non-conduction, it is qualified, if not, it is unqualified.

Preferably, in the calibration method for time-delay characteristics of relays, S3 further includes the following sub-steps: S32, marking a corresponding current level scale on the first adjusting cam 100cam after the relay ends its first calibration operation of the tripping point and the calibration result is qualified. Further, in S32, firstly positioning the relay, then marking the corresponding current level scale(s) on the first adjusting cam 100cam. In S32, marking the tripping point position obtained in the first calibration operation of the tripping point on the first adjusting cam 100cam, conduces to improve the accuracy and efficiency of marking the current level scale.

Preferably, the calibration method for time-delay characteristics of relays further includes S4, that is, checking the supplementary contact performance of the supplementary contact system of the relay again, and marking the rest of the current level scales on the first adjusting cam 100cam in accordance with the calibration results of the tripping point. Further, in S4, positioning the relay in the same manner as in S32, then marking the rest of the current level scales on the first adjusting cam 100cam, so as to improve the consistency and accuracy of the position marked with scales.

It should be pointed out that a right-angle positioning method can be adopted, that is, the product is positioned close to the same reference surface through extrusion of elastic pieces, so as to ensure that the marked positions of diverse products and diverse current levels are consistent; alternatively, means such as cylinders and motors can be used to press and position the product.

In addition, in the calibration method for time-delay characteristics of relays, it is also possible to mark the current level scales, after the relay ends the calibration operation of all tripping points of the current levels, that is, instead of marking the current level scale on the first adjusting cam 100cam in S3, marking all current level scales according to the calibration results in S4.

Preferably, in the calibration method for time-delay characteristics of relays, after two adjacent calibration operation of two tripping points, calculating the difference of the two calibration results and comparing it with an qualified range of difference, if the difference of the twice calibration results is within the qualified range of difference, the relay enters the subsequent steps, otherwise the relay is classified as an unqualified product. The qualified range of difference varies with the specifications of products and is set by the operator based on statistical data and experience.

A calibrating system for time-delay characteristics of relays, not covered by the claims, that applies the calibration method for time-delay characteristics of relays, is also disclosed.

As shown in FIGs. 1-2, 4-8, the calibrating system for time-delay characteristics of relays includes a pre-checking/marking unit, a pre-adjusting unit, a calibrating/cooling subsystem, a current level-marking unit and a terminal-checking/marking unit; the calibrating/cooling subsystem includes at least one calibrating-cooling combination unit, each calibrating-cooling combination unit includes a calibrating unit and a cooling unit; there are one or more calibrating-cooling combination units arranged between the pre-adjusting unit and the terminal-checking/marking unit, the current level-marking unit is arranged between the calibrating unit and the cooling unit of the headed calibrating-cooling combination unit or between a first calibrating-cooling combination unit and a second calibrating-cooling combination unit; the pre-checking/marking unit checks the supplementary contact performance of the supplementary contact system of the relay and marks an unique product status code for the relay before the first-time pre-adjusting operation of the tripping travel of the relay; the pre-adjusting unit is used to executed the first-time or second-time pre-adjusting operation of the tripping travel of the relay; the calibrating unit is used to execute calibration operation of the tripping point of each current level of the relay; the cooling unit is used to cool the relay which has ended the one-time calibration operation of the tripping point; the current level-marking unit marks a corresponding current level scale on the first adjusting cam 100cam after the relay has ended its first calibration operation of the tripping point and the calibration result is qualified; the terminal-checking/marking unit marks the rest of the current level scales on the first adjusting cam 100cam according to the calibration result, after the relay has ended all calibration operation of the tripping point. Further, the calibrating system for time-delay characteristics of relays also includes a control unit respectively communicationally connected to the pre-checking/marking unit, the pre-adjusting unit, the calibrating/cooling subsystem, the current level-marking unit and the terminal-checking/marking unit; the control unit stores the product status information and the travel-debugging parameter X of the relay therein; the pre-adjustment unit reads a product status code of the relay to obtain a corresponding travel-debugging parameter from the control unit; the calibrating/cooling subsystem reads the product status code of the relay to obtain product status information from the control unit, executes calibration operation of the tripping point of the relay according to the product status information of the relay, and uploads the calibration result to the control unit; the terminal-checking/marking unit reads a product status code of the relay to obtain the calibration result from the control unit, and marks the rest of the current level scales on the first adjusting cam 100cam according to the calibration result.

It should be pointed out that the number of the calibrating-cooling combination units included in the calibrating/cooling subsystem is the same as the number of the current levels of the product to be calibrated.

The calibrating system for time-delay characteristics of relays that applies the calibration method for time-delay characteristics of relays, can realize automatic calibration operation of the tripping point of the current level of relays, improving the calibration efficiency and ensuring the accuracy and consistency of the calibration results; moreover, each relay has a unique product status code, so that the whole process of the calibration operation of the tripping point of the relay can be traced.

Preferably, the control system is an upper computer.

As shown in FIG.2, there is one example of the pre-checking/marking unit.

The pre-checking/marking unit includes the first feeding channel 1-0, the first loading mechanism 1-1, the first partitioner 1-2, the supplementary contact performance-checking mechanism 1-3 used to check the supplementary contact performance of the supplementary contact system of the relay, the first marking mechanism 1-4 used to mark a product status code for the relay, the first unloading mechanism 1-6 and the first outlet channel; the first loading mechanism 1-1, the supplementary contact performance-checking mechanism 1-3, the first marking mechanism 1-4 and the first unloading mechanism 1-6 are arranged on the peripheral side of the first partitioner 1-2 in proper order; the first partitioner 1-2 includes a first partitioner turntable, and a plurality of first stations disposed on the first partitioner turntable which are used to accommodate and fix the relay; the first outlet channel is connected to the calibrating/cooling subsystem (the first outlet channel is preferably connected to the first calibrating-cooling combination unit of the calibrating/cooling subsystem).

The first marking mechanism 1-4 can automatically generate a product status code according to the product status information of the relay, and mark the product status code on the relay. Preferably, the first marking mechanism 1-4 is a laser marking machine. As other embodiments, the first marking mechanism 1-4 may also be a pad printing device, a labeling device or a spraying device. It should be pointed out that the product information corresponding to the relay can be input into the first marking mechanism 1-4 through manual set-up, such as manual input; alternatively, the first marking mechanism 1-4 may also obtain the product information corresponding to the relay from the upper computer.

Preferably, as shown in FIG.2, the pre-checking/marking unit further includes the verification-and-code-reading device 1-5, reading and verifying the product status code of the relay. Further, as shown in FIG.2, the first outlet channel includes the first qualified product channel 1-7 and the first unqualified product channel 1-8, when the product status code can be successfully read and the supplementary contact performance is qualified, the relay is unloaded to the first qualified product channel 1-7 by the first unloading mechanism 1-6, when the product status code can not be read and/or the supplementary contact performance is unqualified, the relay is unloaded to the first unqualified channel 1-8 by the first unloading mechanism 1-6.

Preferably, as shown in FIG.2, both the first loading mechanism 1-1 and the first unloading mechanism 1-6 are a device with clamping jaws, both include a clamping jaw used to clamp relays, a driving structure used to drive the clamping jaw to act, and a guiding structure used to guide the clamping jaw, the above structures can be realized though the prior art, and are not described herein.

One example of the pre-adjusting unit is provided as follows.

The pre-adjusting unit includes a second code-reading device used to read the product status code of the relay to obtain the corresponding travel-debugging parameter X from the control unit, a supplementary electrode group used to cooperate with the supplementary contact system of the relay, a pre-adjusting mechanism used to drivingly cooperate with the adjusting screw 100s of the relay, a second feeding channel connected to the first outlet channel of the pre-checking/marking unit, a second outlet channel connected to the calibrating/cooling subsystem, a second loading mechanism used to place the relay in position where the first-time or second-time pre-adjusting operation is executed, and a second unloading mechanism use to unload the relay that has completed the first-time or second-time pre-adjusting operation to the second outlet channel. Further, the pre-adjusting mechanism includes a pre-adjusting motor and a pre-adjusting screwdriver, of the pre-adjusting screwdriver one end is drivingly connected to the output shaft of the pre-adjusting motor, the other end drivingly cooperates with the adjusting screw 100s of the relay, so as to twist the adjusting screw 100s.

It should be pointed out that the second code-reading device reads the product status code of the relay to obtain the corresponding product information, and obtains the corresponding pre-stored travel-debugging parameter X from the control unit/the upper computer according to the product information (mostly product specifications); alternatively, the corresponding travel-debugging parameter X of the relay may also be pre-stored in the control part (e.g., PLC control mechanism/structure) of the pre-adjusting unit.

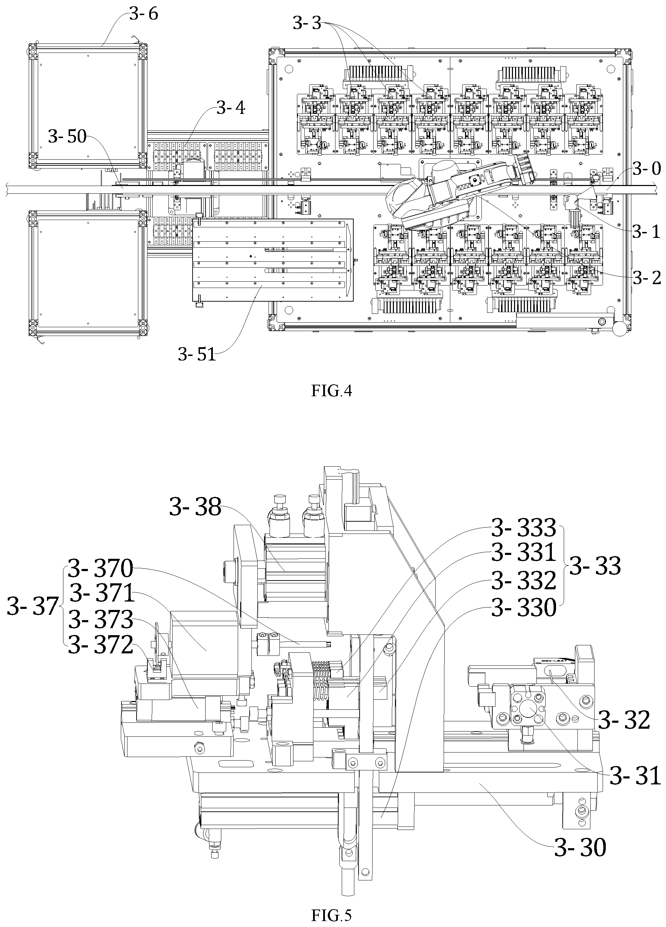

As shown in FIG. 4, there is one example of the calibrating unit.

The calibrating unit includes the calibrating unit's feeding channel 3-0, the calibrating unit's outlet channel, the calibrating unit's code-reading device 3-1, the power supply mode-switching device 3-4, the calibrating unit's loading/unloading mechanism 3-2 and the calibrating mechanism 3-3; the calibrating unit's code-reading device 3-1 reads the product status code of the relay to obtain the product status information of the relay from the control unit, the power supply mode-switching device 3-4 switches the power supply according to the product status information of the relay, inputs a preset current into the relay through the calibrating mechanism 3-3 and keeps a preset time length, the calibrating mechanism 3-3 completes the calibration operation of the tripping point of each current level by means of twisting the first adjusting cam 100cam of the relay, the calibrating unit's loading/unloading mechanism 3-2 is used to load the relay to be calibrated from the calibrating unit's feeding channel 3-0 to the calibrating mechanism 3-3, and unload the relay that completes calibration operation from the calibrating mechanism 3-3 to the calibrating unit's outlet channel. Further, as shown in FIG.4, the calibrating unit's outlet channel includes the calibrating unit's qualified product outlet channel 3-50 and the calibrating unit's unqualified product outlet channel 3-51.

The power supply mode-switching device 3-4 switches diverse output power supplies according to the specifications of the relay, for example, the power supply mode-switching device 3-4 is equipped with at least two sets of power supplies, one set is a No.1 power supply with a current range 0-40A, and the other set is a No.2 power supply with a current range more than 40A.

It should be pointed out that the calibrating unit of the first calibrating-cooling combination unit of the calibrating/cooling subsystem is the calibrating unit executing calibration operation of the first tripping point of the current level of the relay, the calibrating unit's qualified product outlet channel 3-50 will convey the qualified product to the next process, and the calibrating unit's unqualified product outlet channel 3-51 will convey the unqualified product to the pre-adjusting unit, which will execute the second-time pre-adjusting operation of the unqualified product. Of the other calibrating units, the calibrating unit's qualified product outlet channels 3-50 will convey the qualified products to the next process, and the calibrating unit's unqualified product outlet channels 3-51 will convey the unqualified products to a corresponding convergence place.

As shown in FIG.5, there is one example of the calibrating mechanism 3-3.

The calibrating mechanism includes the calibrating mechanism base 3-30, and the first pressing mechanism, the second pressing mechanism 3-33, the third pressing mechanism 3-38 and the cam-adjusting mechanism 3-37 respectively disposed on the calibrating mechanism base 3-30; the first pressing mechanism and the second pressing mechanism 3-33 are arranged opposite each other, and a calibration station used to place the relay to be calibrated is disposed therebetween, the first pressing mechanism and the second pressing mechanism 3-33 press the relay from both sides opposite each other, and the third pressing mechanism 3-38 presses the relay to be calibrated from the side opposite the calibrating mechanism base 3-30; the second pressing mechanism 3-33 includes the calibrating mechanism's main electrode group 3-332 and the calibrating mechanism's supplementary electrode group 3-333, respectively electrically connected to the main contact system and the supplementary contact system of the relay to be calibrated, the cam-adjusting mechanism 3-37 and the first adjusting cam 100cam of the relay drivingly cooperate with each other, so as to twist the first adjusting cam 100cam. Further, the cam-adjusting mechanism 3-37 includes the cam-adjusting drive structure 3-372, the cam-adjusting motor 3-371 and the cam screwdriver 3-370, of the cam screwdriver 3-370 one end is connected to the output shaft of the cam-adjusting motor 3-371, and the other end drivingly cooperates with the first adjusting cam 100cam, the cam-adjusting motor 3-371 is disposed on the cam-adjusting drive structure 3-372, which acts to drive the cam screwdriver 3-370 to move toward or backward the first adjusting cam 100cam.

Preferably, as shown in FIG.5, the first pressing mechanism includes the first pressing cylinder 3-31 and the first positioning structure 3-32, the first positioning structure 3-32 is used to limit the travel of the first pressing cylinder 3-31.

Preferably, as shown in FIG.5, the second pressing mechanism 3-33 further includes the second pressing cylinder 3-330, the calibrating mechanism's main electrode group 3-332 and the calibrating mechanism's supplementary electrode group 3-333 are drivingly connected to the second pressing cylinder 3-330, respectively. Further, as shown in FIG.5, the second pressing mechanism 3-333 further includes the second positioning structure 3-331 used to limit the travel of the second pressing cylinder 3-330.

The first positioning structure 3-32 and the second positioning structure 3-331 cooperate with each other, so as to avoid the relay from deforming or damaging under the compression between the first pressing mechanism and the second pressing mechanism 3-33, and ensure that the calibrating mechanism's main electrode group 3-332 and the calibrating mechanism's supplementary electrode group 3-333 cooperate with the main contact system and the supplementary contact system of the relay in position, respectively.

Preferably, as shown in FIG.5, the calibrating mechanism's main electrode group 3-332 and the calibrating mechanism's supplementary electrode group 3-333 both include a plurality of electrode assemblies arranged side by side, each of which includes an electrode stem and an electrode stem-resetting spring, the electrode stem is movably inserted on the second pressing cylinder 3-330, and the electrode stem-resetting spring sleeves the electrode stem, so as to avoid damage to the relay by hard contact between the electrode stem and the contact of the relay. Further, the second positioning structure 3-331 is a positioning pin, and the calibrating mechanism's main electrode group 3-332 passes by the positioning pin, then cooperates with the main contact system of the relay.

Preferably, as shown in FIG.5, the cam-adjusting mechanism 3-37 further includes the in-position checking structure 3-372 used to check whether the cam screwdriver 3-370 is aligned with and inserted into the operating groove of the adjusting cam 100cam. Preferably, the in-position checking mechanism 3-372 is a photoelectric sensing device.

Preferably, as shown in FIG. 4, the calibrating unit's loading/unloading mechanism 3-2 is actualized in the form of a robotic arm + a clamping jaw, with high flexibility, which can adapt multiple calibrating mechanisms 3-3 for loading and unloading.

It should be pointed out that the calibrating unit can be used singly for executing calibration operation of the tripping points of diverse rated current levels of the relay. When the calibrating unit is used singly, the calibrating unit's feeding channel 3-0, the calibrating unit's discharge channel, the calibrating unit's loading/unloading mechanism 3-2 and the calibrating unit's code-reading device 3-1 can be optionally setup.

As shown in FIG.1, the current level-marking unit is arranged between the calibrating unit and the cooling unit of the first calibrating-cooling combination unit of the calibrating/cooling subsystem, preferably, the current level-marking unit is located at the inlet of the cooling unit. In other embodiments, the current level-marking unit is arranged between the first calibrating-cooling combination unit and the second calibrating-cooling combination unit of the calibrating/cooling subsystem, preferably, the current level-marking unit is located at the outlet of the cooling unit of the first calibrating-cooling combination unit.

Preferably, the current level-marking unit may be a laser printing device, a pad printing device, a labeling device or a spraying device.

It should be pointed out that the calibrating unit includes a calibrating unit controlling mechanism, the calibrating unit controlling mechanism includes a PLC control chip, which controls the power supply mode-switching device 3-4 to switch power supply (a first set current and a second set current), the time length of the power supply mode-switching device 3-4 outputting current (first set time length and second set time length), and the act process of calibrating mechanism 3-3.

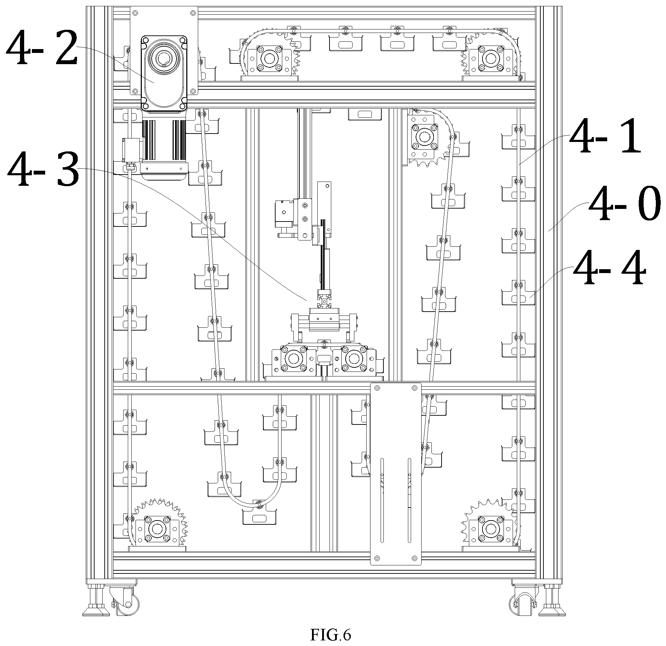

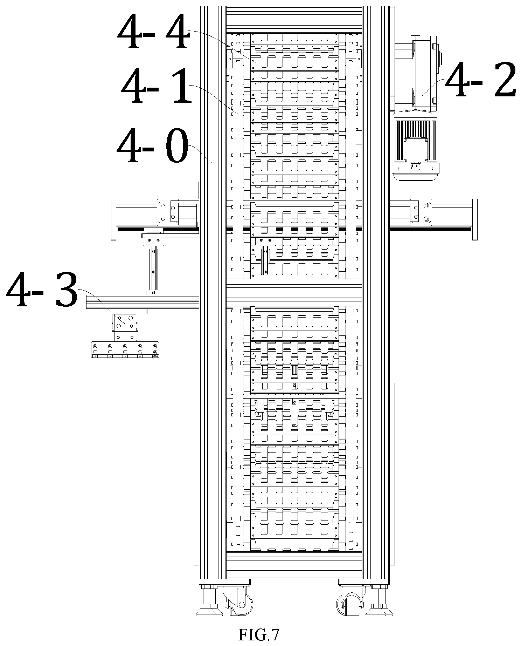

As shown in FIGs.6 and 7, there is one example of the cooling unit.

The cooling unit includes the cooling tower frame 4-0, the cooling tower 'conveying belt 4-1 disposed in the cooling tower frame 4-0, a plurality of storing baskets 4-4 for storing relays distributed on the cooling tower' conveying belt 4-1, the cooling tower' driving structure 4-2 drivingly cooperating with the cooling tower 'conveying belt 4-1 for driving the cooling tower 'conveying belt 4-1 to rotate in circulation within the cooling tower frame 4-0, and the cooling tower's loading/unloading mechanism 4-3 for putting and taking the relay into and out of the storing basket 4-4; each time the cooling tower's loading/unloading mechanism 4-3 acts, it firstly takes out the relays placed in the storing basket 4-4 at a waiting station and place into the fifth unit, then puts the relays to be cooled into the storing basket 4-4, next the cooling tower' conveying belt 4-1 steps once and brings another storing basket 4-4 into the waiting station.

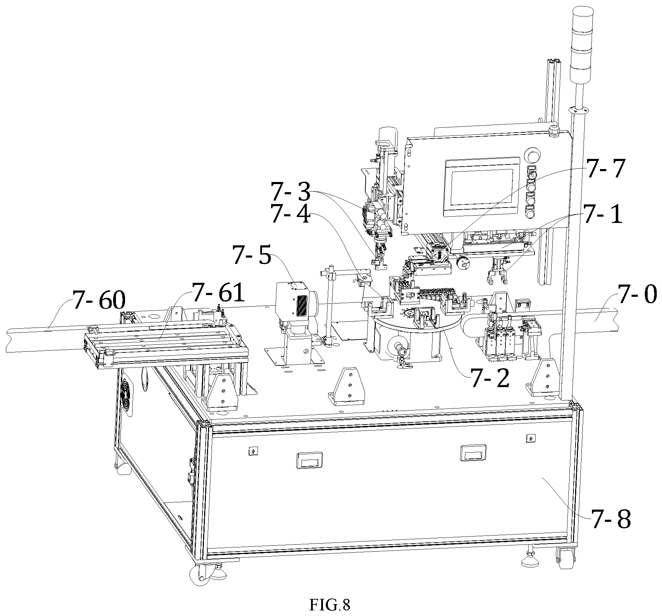

As shown in FIG.8, there is one example of the terminal-checking/marking unit.

The terminal-checking/marking unit checks the supplementary contact performance of the supplementary contact system of the relay again after the relay completes calibration operation of the tripping point. It includes the terminal feeding channel 7-0, the terminal feeding mechanism 7-1, the terminal partitioner 7-2, the terminal supplementary contact performance-checking mechanism 7-7, the terminal unloading mechanism 7-3, the terminal code-reading device 7-4, the terminal marking mechanism 7-5 and the terminal unloading channel; the terminal feeding channel 7-0, the terminal supplementary contact performance-checking mechanism 7-7, the terminal code-reading device 7-4 and the terminal marking mechanism 7-5 are arranged outside the circumference of the terminal partitioner 7-2 in proper order, the terminal feeding channel 7-0 is connected to the calibrating/cooling subsystem, the terminal partitioner 7-2 includes a terminal partitioner turntable and a plurality of terminal stations disposed on the terminal partitioner turntable, and the terminal partitioner turntable rotates to drive a plurality of terminal stations to rotate in circulation; the terminal feeding mechanism 7-1 loads the relay from the terminal feeding channel 7-0 into the terminal station, the terminal supplementary contact performance-checking mechanism 7-7 checks the supplementary contact performance of the supplementary contact system of the relay, the terminal code-reading device 7-4 reads the product status code of the relay to obtain calibration results and product status information from the control unit, the terminal marking mechanism 7-5 marks the rest of the current level scales on the first adjusting cam 100cam of the relay, and the terminal unloading mechanism 7-3 is used to unload the relay from the terminal station to the terminal outlet channel.

As shown in FIG. 8, the terminal partitioner 7-2 includes 4 terminal stations distributed on it along the circumference of the terminal partitioner turntable.

As shown in FIG.8, the terminal unloading channel includes a terminal qualified product outlet channel for carrying and conveying qualified products and a terminal unqualified product outlet channel for carrying unqualified products. Further, the terminal unqualified product outlet channel includes a plurality of channels arranged side by side, each of which corresponds to one sort of unqualified products; the terminal unqualified product outlet channel includes a channel used to carry and convey the relay with unqualified supplementary contact performance, a channel used to carry and convey the relay marked with unqualified current gear scales, and a channel used to carry and convey the relay of which the product status code cannot be read normally.

Preferably, the terminal marking mechanism 7-5 may be a laser printing device, a pad printing device, a labeling device or a spraying device.

As shown in FIG. 1, there is one example of the calibrating system for time-delay characteristics of relays, not covered by the claims.

The calibrating system for time-delay characteristics of relays in this example includes a control unit, and a pre-checking/marking unit, a pre-adjusting unit, a calibrating/cooling subsystem and a terminal-checking/-marking unit, which are arranged in proper order and respectively connected to the control unit; the calibrating/cooling subsystem includes two calibrating-cooling combination units, which are a first calibrating-cooling combination unit and a second calibrating-cooling combination unit, arranged in proper order between the pre-adjusting unit and the terminal-checking/marking unit, respectively, a current level marking unit is arranged between the calibrating unit and the cooling unit of the first calibrating-cooling combination unit.

The calibrating system for time-delay characteristics of relays in this example can be used to continuously complete the calibration operation of the tripping points of the two current levels of the relay.

It should be pointed out that of calibrating system for time-delay characteristics of relays each unit includes an independent unit PLC control system, control program is pre-stored in the unit PLC control system to control the action of the components of each unit; the control unit is used to count the operating data of each unit of the system and transmit each unit according to needs, so as to realize the connection operation of each unit.

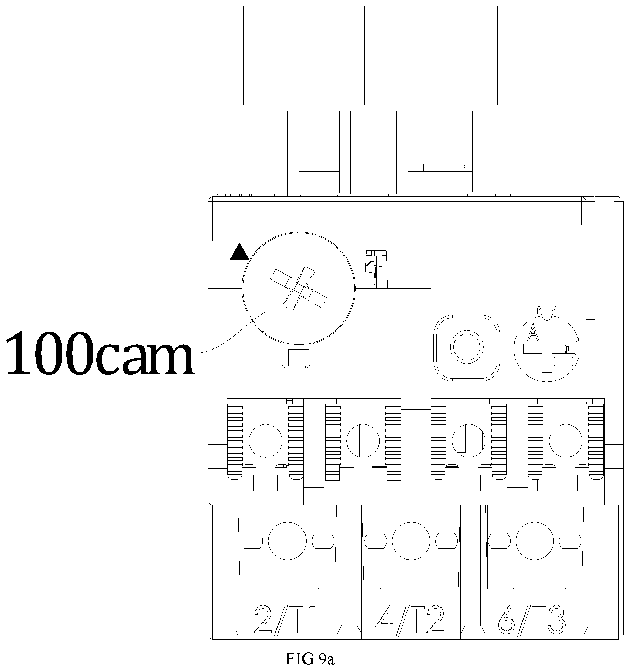

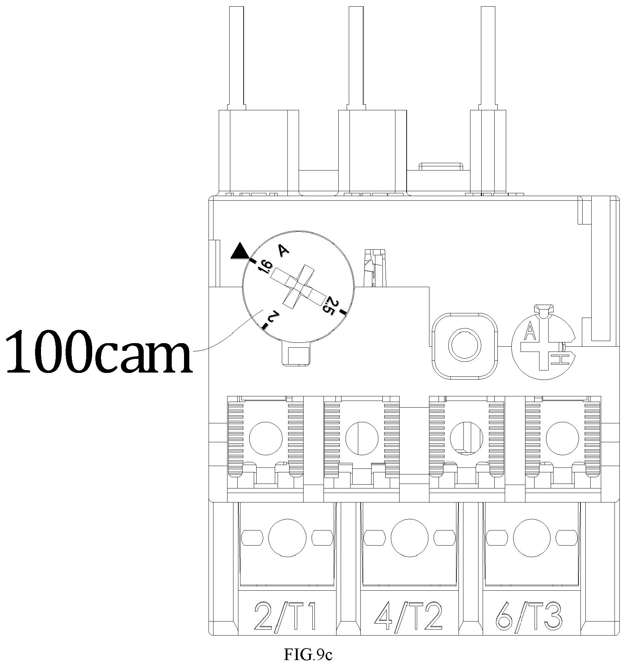

As shown in FIGs.3 and 9a-9c, there is one example of the relay.

The relay in this example includes a bimetallic strip, an adjustment screw 100s, a first adjusting cam 100cam, a main contact system and a supplementary contact system, the supplementary contact system includes a supplementary normally-closed contact system 100c and a supplementary normally-opened contact system 100o, it includes three current levels of 1.6, 2.0, and 2.5A, as shown in FIG.9a, any current level scales are not marked on the first adjusting cam 100cam; in practice, calibration operation may be executed only of the tripping points of the 2.5 and 1.6A current levels of the relay, that is, calibration operation is executed of the tripping points of the maximum and minimum current levels.

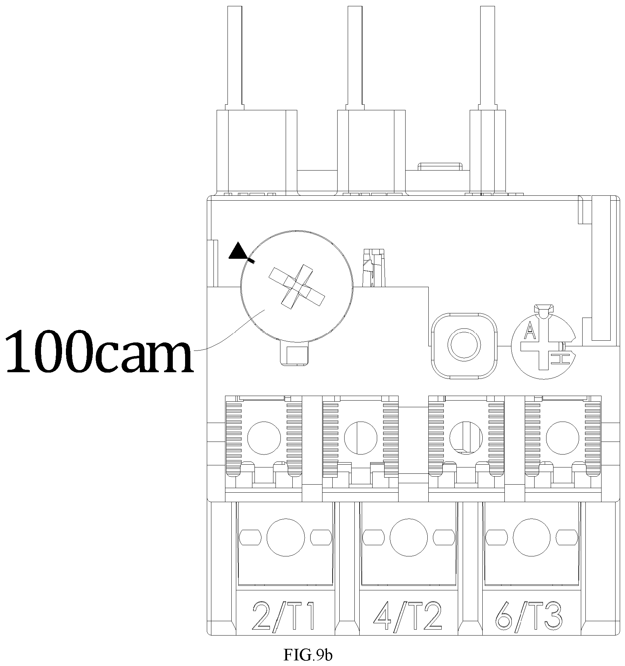

When the relay in this example executes calibration through calibrating system for time-delay characteristics of relays in above example, the first calibrating-cooling combination unit completes calibration operation of the tripping point of the 2.5A current level, if the calibration result is qualified, the scale of the 2.5A current level is marked on the first adjusting cam 100cam (as shown in FIG.9b), then the second calibrating-cooling combination unit completes calibration operation of the tripping point of the 1.6A current level, finally the terminal-checking/marking unit calculates the scale position of the 2.0A current level based on the above two calibration results, next the scales of the 1.6A and 2.0 A current levels are marked on the first adjusting cam 100cam, respectively(as shown in FIG.9b).

Specifically, calibration operation is executed of the tripping points of the maximum current level (2.5A current level) and the minimum current level (1.6A current level) to give an angle 180° between the two, in this way the minimum current level (1.6A current level) is positioned at 0°, the 2.0A current level is positioned at 80°, and the 2.5A current level is positioned at 180°.

## Claims

1. A calibration method for time-delay characteristics of switch-with-bimetal, comprising the operation of:

   pre-adjusting operation of a tripping travel, that is: adjusting the tripping travel of a switch-with-bimetal through adjustment to the relative position of a bimetallic strip of the switch-with-bimetal and a transmission structure;
   calibration operation of a tripping point, executing calibration operation of the tripping point of a current level "a" of the switch-with-bimetal after ending the pre-adjusting operation of the tripping travel, the current level "a" representing any one of current levels of the switch-with-bimetal, **characterized in that** it provides: inputting a first calibrating current to a main contact system of the switch-with-bimetal and keeping a first set time length, the first calibrating current being 2-6 times a rated current of the current level "a" of the switch-with-bimetal, the first set time length being 10-120s, then inputting a second calibrating current to the main contact system of the switch-with-bimetal and keeping a second set time length, the second calibrating current being 1.05-1.2 times the rated current of the current level "a" of the switch-with-bimetal, the second set time length being 1-60s; at the end of the second set time length, twisting an adjusting cam (100cam) used for adjusting the current level of the switch-with-bimetal until the main contact system or a supplementary normally-closed contact system (100c) of the switch-with-bimetal is disconnected, keeping inputting the second calibrating current to the main contact system of the switch-with-bimetal in the process of twisting the adjusting cam;

for the switch-with-bimetal including a plurality of current levels, just repeating the calibration operation of the tripping point;

after a first time of calibration operation of the tripping point of the switch-with-bimetal is done, if a calibration result is unqualified, repeating the pre-adjusting operation of the tripping travel, and then executing calibration operation of the tripping point again.

2. The calibration method according to claim 1, wherein the adjusting cam (100cam) is brought to rotate through a cam-adjusting motor; when the cam-adjusting motor drives the adjusting cam to rotate to enable the supplementary normally-closed contact system (100c) of the switch-with-bimetal to break contact, the angle where the cam-adjusting motor is positioned is the calibration result, if the calibration result is within an qualified angle range, the calibration result is qualified, if the calibration result is not within the qualified angle range, the calibration result is unqualified.

**Patentansprüche**

1. Kalibrierverfahren für Zeitverzögerungskennlinien eines Schalters mit Bimetall, umfassend die folgenden Betriebsschritte:

Voreinstelloperation eines Auslösewegs, das heißt: Einstellen des Auslösewegs eines Schalters mit Bimetall durch Einstellen der relativen Position eines Bimetallstreifens des Schalters mit Bimetall und einer Übertragungsstruktur;
Kalibrieroperation eines Auslösepunkts, wobei eine Kalibrieroperation des Auslösepunkts einer Stromstufe "a" des Schalters mit Bimetall nach Beenden der Voreinstelloperation des Auslösewegs ausgeführt wird, wobei die Stromstufe "a" eine beliebige von Stromstufen des Schalters mit Bimetall darstellt, **dadurch gekennzeichnet, dass** es Folgendes vorsieht: Einspeisen eines ersten Kalibrierstroms in ein Hauptkontaktsystem des Schalters mit Bimetall und Aufrechterhalten über eine erste eingestellte Zeitdauer, wobei der erste Kalibrierstrom das 2- bis 6-Fache eines Nennstroms der Stromstufe "a" des Schalters mit Bimetall beträgt, wobei die erste eingestellte Zeitdauer 10-120 s beträgt, dann Einspeisen eines zweiten Kalibrierstroms in das Hauptkontaktsystem des Schalters mit Bimetall und Aufrechterhalten über eine zweite eingestellte Zeitdauer, wobei der zweite Kalibrierstrom das 1.05- bis 1.2-Fache des Nennstroms der Stromstufe "a" des Schalters mit Bimetall beträgt, wobei die zweite eingestellte Zeitdauer 1-60 s beträgt; am Ende der zweiten eingestellten Zeitdauer, Drehen einer Einstellnocke (100cam), die zum Einstellen der Stromstufe des Schalters mit Bimetall verwendet wird, bis das Hauptkontaktsystem oder ein zusätzliches normalerweise geschlossenes Kontaktsystem (100c) des Schalters mit Bimetall geöffnet wird, wobei das Einspeisen des zweiten Kalibrierstroms in das Hauptkontaktsystem des Schalters mit Bimetall während des Vorgangs des Drehens der Einstellnocke beibehalten wird;

für den Schalter mit Bimetall, der eine Vielzahl von Stromstufen aufweist, einfaches Wiederholen der Kalibrieroperation des Auslösepunkts; nachdem eine erstmalige Kalibrieroperation des Auslösepunkts des Schalters mit Bimetall durchgeführt wurde, und zwar wenn ein Kalibrierergebnis ungenügend ist, Wiederholen der Voreinstelloperation des Auslösewegs und anschließendes erneutes Ausführen der Kalibrieroperation des Auslösepunkts.

2. Kalibrierverfahren nach Anspruch 1, wobei die Einstellnocke (100cam) durch einen Nockeneinstellmotor in Drehung versetzt wird; wobei dann, wenn der Nockeneinstellmotor die Einstellnocke dreht, um zu ermöglichen, dass das zusätzliche normalerweise geschlossene Kontaktsystem (100c) des Schalters mit Bimetall den Kontakt unterbricht, der Winkel, an dem der Nockeneinstellmotor positioniert ist, das Kalibrierergebnis ist, wobei dann, wenn das Kalibrierergebnis innerhalb eines qualifizierten Winkelbereichs liegt, das Kalibrierergebnis qualifiziert ist, wobei dann, wenn das Kalibrierergebnis nicht innerhalb des qualifizierten Winkelbereichs liegt, das Kalibrierergebnis unqualifiziert ist.

## Revendications

1. Procédé d'étalonnage pour des caractéristiques de retard de commutateur à bimétal, comprenant les opérations suivantes :

   une opération de préréglage d'une course de déclenchement, c'est-à-dire :

   réglage de la course de déclenchement d'un commutateur à bimétal à travers un réglage de la position relative d'une lame bimétallique du commutateur à bimétal et d'une structure de transmission ;

   une opération d'étalonnage d'un point de déclenchement, en exécutant l'opération d'étalonnage du point de déclenchement d'un niveau de courant "a" du commutateur à bimétal après avoir terminé l'opération de préréglage de la course de déclenchement, le niveau de courant "a" représentant l'un quelconque des niveaux de courant du commutateur à bimétal, **caractérisé en ce qu'**il fournit : l'entrée d'un premier courant d'étalonnage dans un système de contact principal du commutateur à bimétal et le maintien d'une première durée définie, le premier courant d'étalonnage étant de 2 à 6 fois un courant nominal du niveau de courant "a" du commutateur à bimétal, la première durée définie étant de 10 à 120 s, puis l'entrée d'un second courant d'étalonnage dans le système de contact principal du commutateur à bimétal et le maintien d'une seconde durée définie, le second courant d'étalonnage étant de 1.05 à 1.2 fois le courant nominal du niveau de courant "a" du commutateur à bimétal, la seconde durée définie étant de 1 à 60 s ; à la fin de la seconde durée définie, le fait de tourner une came de réglage (100cam) utilisée pour régler le niveau de courant du commutateur à bimétal jusqu'à ce que le système de contact principal ou un système de contact supplémentaire normalement fermé (100c) du commutateur à bimétal soit déconnecté, en continuant à entrer le second courant d'étalonnage dans le système de contact principal du commutateur à bimétal dans le processus consistant à tourner la came de réglage ;

   pour le commutateur à bimétal comprenant une pluralité de niveaux de courant, la simple répétition de l'opération d'étalonnage du point de déclenchement ;

   une fois une première opération d'étalonnage du point de déclenchement du commutateur à bimétal réalisée, si un résultat d'étalonnage n'est pas qualifié, la répétition de l'opération de préréglage de la course de déclenchement, puis l'exécution, à nouveau, de l'opération d'étalonnage du point de déclenchement.

2. Procédé d'étalonnage selon la revendication 1, dans lequel la came de réglage (100cam) est amenée à tourner par l'intermédiaire d'un moteur de réglage de came ; lorsque le moteur de réglage de came entraîne la came de réglage en rotation pour permettre au système de contact supplémentaire normalement fermé (100c) du commutateur à bimétal de rompre le contact, l'angle où le moteur de réglage de came est positionné est le résultat d'étalonnage, si le résultat d'étalonnage se situe dans une plage d'angles qualifiée, le résultat d'étalonnage est qualifié, si le résultat d'étalonnage ne se situe pas dans la plage d'angles qualifiée, le résultat d'étalonnage est non qualifié.

control unit

pre-checking/
marking
unit

pre-adjusting

unit

calibrating
unit

current
level-marking
unit

cooling unit

calibrating
unit

cooling unit

terminal-
checking/
marking
unit

FIG.1

FIG.2

FIG.3

FIG.4

FIG.5

4-2

4-3

4-1

4-0

4-4

FIG.6

FIG.7

FIG.8

100cam

FIG.9a

100cam

FIG.9b

FIG.9c

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 103645436 A